Europäisches Patentamt

European Patent Office

Office européen des brevets

(11) Publication number: **0 654 822 A1**

## EUROPEAN PATENT APPLICATION

(21) Application number: **93830463.1**

(51) Int. Cl.6: **H01L 23/40**

(22) Date of filing: **19.11.93**

(43) Date of publication of application:
**24.05.95 Bulletin 95/21**

(84) Designated Contracting States:
**DE FR GB IT**

(71) Applicant: **BULL HN INFORMATION SYSTEMS ITALIA S.p.A.**
**Via Martiri d'Italia 3**
**I-10014 Caluso (Torino) (IT)**

(72) Inventor: **Mondori, Luciano**
**Via A. Righi, 4**
**I-20082 Binasco (Milan) (IT)**

(74) Representative: **Falcetti, Carlo et al**
**c/o JACOBACCI & PERANI S.p.A.**
**Via Visconti di Modrone, 7**
**I-20122 Milano (IT)**

(54) **Heat sink assembly for integrated circuit.**

(57) Heat sink assembly for naked integrated circuit (19) mounted on a printed circuit board (21) comprising a torsion bar (1) ended in two arms (7,8) perpendicular to the bar and parallel each to the other, the arms having a free end bent to form a hooking element (9,10) a heat sink centering and preloading frame for centering a heat sink and preloading the torsion bar, the frame having a first surface for resting on a printed circuit board and a second surface opposite to the first, the torsion bar overlaying the second surface with the hooking elements (9,10) hooked in recesses (18) formed in the frame (2) close to the first surface, so as to torsionally preload the bar, a heat sink (3) formed from a radiating plate housed in the frame (2) and means (4,5) for clamping the frame (2) to a printed circuit board (21) in centered position as to a die (19) to be cooled, the torsion bar (1) urging the heat sink on the die (19) with a predetermined force assuring a uniform contact pressure distribution independently of the die mounting incidence on the printed circuit board (21).

FIG.1

The present invention relates to a heat sink assembly for naked integrated circuit.

A crucial problem in the use of integrated circuits is the dissipation of the heat developed by such circuits during operation.

To this purpose finned dissipating elements, known as heat sinks, having high thermal conductivity are used, which are tightly coupled to the integrated circuit package or are integral with the package.

The thermal transfer efficiency of these heat sinks is limited by the thermal drop occurring in the insulating material, generally epoxy resin or like, which separates the integrated circuit chip or die from its container, hence from the radiating element or heat sink.

To overcome this limitation packages have been devised where the integrated circuit substrate is soldered to the heat dissipator.

This arrangement, used in solid state power circuits, cannot be used with large scale integrated circuits having a remarkable number of input/output pins which must be fixed to a printed circuit board or more generally to an intermediate ceramic or plastic support with batch processes, by means of equipment inconsistent with the presence of a heat sink steady with the die.

Moreover, the presence of a heat sink integral with the die and necessarily having a size much greater than the one of the integrated circuit, even in extension along the plane of the printed circuit board supporting the electronic components precludes the access to a broad surface of the printed circuit board, which preferably should be free from encumbrances to allows at least for access to test pads, if not for the installation of electronic components.

These limitations are overcome by the heat sink assembly which is the object of the present invention allowing for the use of naked dies, mounted on printed circuit boards by known techniques, and providing a direct contact of the die with a dissipating element, removably fixed to the printed circuit board.

The technical problem which must be solved in adapting this approach is the one to assure an adequate contact pressure between the die and the heat sink. The pressure must be gradually applied and must be uniformly distributed on the die surface and local stresses must be avoided which could damage the semiconductor die (and its connections) particularly brittle and fragile.

At the same time a distribute contact must be assured adaptive to possible errors in parallelism between the die surface and the plane of the printed circuit board to which the heat sink must be fastened.

It must be further assured that vibrations and shocks do not cause the detachment, even casual, of the heat sink from the die.

This problem is solved by providing a heat sink assembly comprising a resilient torsion bar housed in a fitting formed in a dissipation element and fastened in preloaded torsion state by means of two ending torsion arms, to a dissipation element positioning frame. The frame is secured to the printed circuit board by suitable fixing means so that the dissipator overlays and is centered relative to a die from which the heat must be drained and dissipated.

Once the positioning frame is secured to the printed circuit board, a plane surface of the dissipator urges into the back die surface (by convention the surface opposite to the one where the circuit layour and the input/output pads are formed) with a controlled force which depends on the preloading state of the torsion bar and is affected in neglectable way by tickness and installation allowances of the die and the dissipator.

In addition the torsion bar acts in a central position of the dissipator allowing a broad orientation freedom so that the dissipator matches in position the die position.

Securing of the heat sink assembly to the printed circuit board is reversible so that the assembly can be easily and integrally removed and allows for verification and test operations on the printed circuit board.

The features and the advantages of the present invention will appear more clearly from the following description of a preferred form of embodiment and from the enclosed drawings where:

- figure 1 shows in exploded perspective view a heat sink assembly embodied in accordance with the present invention and having a load element formed by a torsion bar;
- figure 2 shows in perspective view the heat sink assembly of figure 1 assembled and ready to mount on a printed circuit board;
- figure 3 shows in perspective view the heat sink assembly of figures 1,2 secured to a printed circuit board;
- figure 4 is a diagrammatic view of the loads acting on the torsion bar of the figure 1 assembly, according to a view in the direction of the torsion bar;
- figure 5 is a diagrammatic view of the loads acting on the torsion bar of the figure 1 assembly, according to a view perpendicular to the torsion bar,
- figure 6 shows in perspective exploded view a first modification of the embodiment of figure 1,
- figure 7 shows in perspective exploded view a second modification of the embodiment of figure 1.

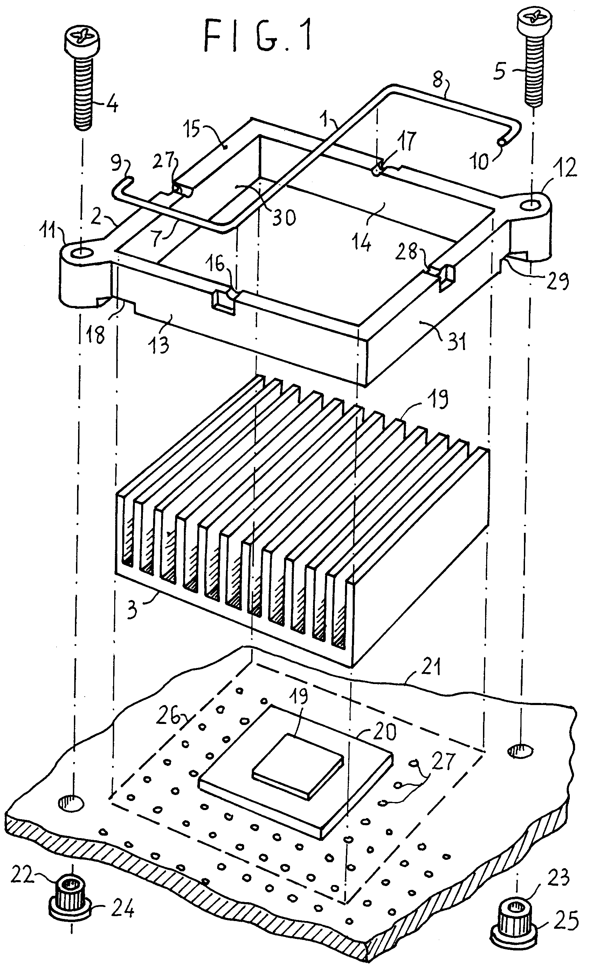

Referring to figure 1 the heat sink assembly of the invention comprises a thin spring steel bar 1, a frame preferably in plastic material, a dissipating element, in high thermal conductivity material, preferably aluminium section and fastening means comprising two screws 4,5.

The spring steel bar 1, of round section, is shaped by cold bending so a to form a double angle element comprising a central portion 1, operative as torsion bar, ending in two arms 7,8 respectively, perpendicular to the central portion 1 and parallel each to the other, operative as torsion bar loading arms.

The free end of the arms is inwardly right angle bent in the extending direction of the torsion bar 1 to form two hooking elements 9,10 respectively.

For example the torsion bar may have a section with diameter in the order of 1,3 mm and a lenght in the order of 48 mm, the lenght of the arms 7,8, equal to each other, being in the order of 20 mm.

The frame 2, preferably square and obtained by plastic molding, comprises four side elements forming a square section hollow prismatic body.

Two opposite apexes of the frame 2 are provided with cylindrical eylets 11,12, having axis parallel to the one of the primatic body, the eylets 11,12 receiving screws 4 and 5.

The lower face of the prismatic body forms a bearing surface of the frame 2 against a printed circuit board.

Two opposite side plates 13,14 of the frame 2 have, at their median section, on the frame upper face 15, opposite and parallel to the lower face, two saddles 16,17 receiving and positioning the torsion bar 1.

At or near to the frame lower face, the opposite side plates 13,14, each have, at the end proximate to eylets 11,12 respectively, an elongated latching recess for housing one of the hooking elements 9,10.

The recess and hooking element pair forms a composite slide-hinge constraint preventing any traverse of the hooking element from the plane of the printed circuit board.

One of such recesses, referenced by numeral 18, is shown in figure 1.

Similar positioning saddles 27,18 and similar housing recesses (one visible in figure 1 and referenced by numeral 29) are provided in the other pair of opposite side plates 30,31 allowing the installation of the torsion bar on the frame, in one or the other of two positions, orthogonal each other, at choice.

When the hooking elements 9,10 of the torsion bar are inserted in their related latching recesses as 18, the torsion bar rests in the saddles in a torsional preload state defined by a torsion constant K of the bar and by the torsion angle $\phi$ imposed to it by the hooked arms 7,8.

It must noted that the preloaded torsion state is obtained independently of and without intervention of other elements, such as the die or the printed circuit board.

Indicatively the frame sides may have a lenght in the order of 45 mm and form a square section prismatic housing having side width in the order of 38 mm and height in the order of 7 mm.

The heat sink 3 is inserted in this housing from the lower face of the frame.

The heat sink 9 is formed in conventional way from a plate having a plurality of radiating fins 19 perpendicular to the plate and parallel each to the other.

When the heat sink is fully inserted in the housing the torsion bar 1 is inserted in a groove formed by two adjacent fins 19A,19B in the median section of the heat sink.

Clearly the heat sink size corresponds to the one of the housing formed by the frame.

Therefore, indicatively the heat sink 3 may have a square base plate with side lenght in the order of 38 mm, thickness in the order of 5 mm and radiating fin height in the order of 15-20 mm.

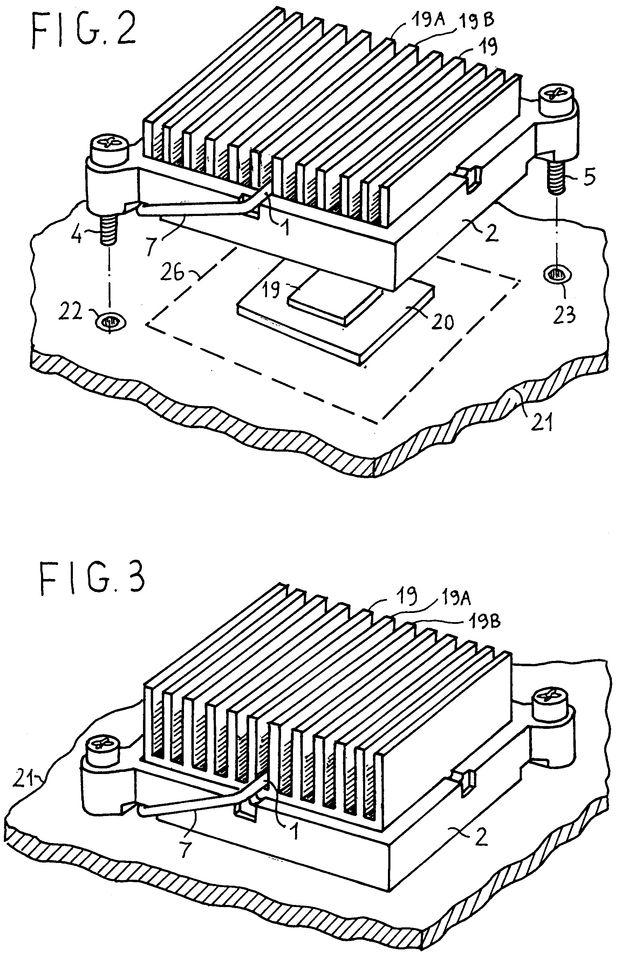

The set so assembled, as shown in figure 2, with screws 4 and 5 inserted in the corresponding eylets 11,12 may be laid down on an integrated circuit die mounted on a printed circuit board and may be secured to the board by screws 4,5

Figure 1 shows a die 19 having a size in the order of 10x10x0,8 mm mounted on a intermediate ceramic support 20 for instance by soldering technique known as flip-chip bonding.

The intermediate ceramic support 20 having size in the order of 20x20x1 mm may be bonded to a printed circuit board 21 by the same technique.

Board 21 is provided with threaded inserts 22,23 fixed to the board with the technique known as "press-fit". The inserts have a ledge 24,25.

The screws 4 and 5 are screwed in the inserts 22,23 and provide the fastening of the heat sink assembly to the board 21, as shown in figure 3.

Heat sink and frame overlap a printed circuit board area whose boundary is identified in figure 1 by the dotted line square 26.

Within such area test pads 27 may be present, easily accessible by removal of the heat sink assembly.

The frame 2 height is suitably selected so as to be about 1 mm less than the sum of
- the intermediate ceramic support 20 thickness
- the die 19 thickness
- the dissipating plate 3 thickness and

- the depth of saddles 16,17.

In this way when the frame 2 is secured to the board 21, the torsion bar 1 interferes with the dissipation plate 3 urging it against the die and at the same time resiliently yielding, owing to a slight rotation of the arm 7,8 which gradually increases the preloaded torsional state of the bar, up to a predetermined value.

Therefore a controlled contact force between dissipator and die is assured. The force is centered on the die irrespective of the incidence taken by the dissipator relative to the printed circuit board surface.

Therefore the dissipator may adjust its position in perfect contact of the die surface and take the required incidence without modification of the load conditions and without development of undesired non uniform pressure distribution on the die.

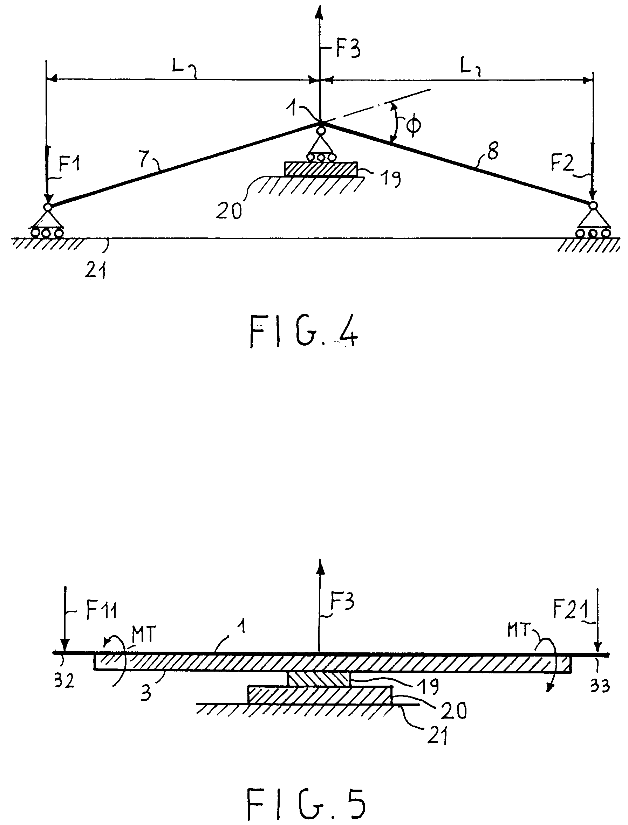

This effect is more clearly explained with reference to the load diagrams of figures 4 and 5 where the second order effects due to flexure are neglected.

In figure 4 the torsion bar 1 is shown in section view according to a plane perpendicular to its lenght.

Arrow F1 is the force applied by the hooking constraint to the arm 7 end.

Arrow F2 is the force applied by the hooking contstraint to the arm 8 end.

For the nature of the constraints the forces F1,F2 act perpendicularly to the plane of the printed circuit board.

Arrow F3 is the reaction force exerted on bar 1 by the die 19, through the dissipation plate 3.

Since by design the bar 1 is centered on the die 19 and the two arms 7,8 have equal lenght, it necessarily occurs that

$$F1 = F2 \text{ and } |F3| = |F1 + F2| = 2F1$$

Even force F3 is perpendicular to the plane of the printed circuit board.

The value of $F3 = 2F1 = 2F2$ does not depend on the incidence of the die 19 and the plate 3, relative to the printed circuit board, at least for small deviations from the state of parallelism, but only on the torsional state of bar 1.

Named $\phi$ the torsion angle imposed to the bar by arms 7,8, owing to the contraints, and named K the torsion constant of the bar, the twisting moment applied to the bar by arms 7,8 is

$$MT = K\phi$$

hence $F2 = F1 = MT/L$ where L is the projection of the arm 7,8 lenght on the printed circuit board plane.

The torsional state of the bar essentially depends on the distance of bar 1 from the constrain plane formed by the frame lower surface, hence on the preload state imposed by the frame height and on the interference between dissipator 3 and die 19 which is not modified in substantive way by size allowances.

It may also be noted that force F1 is equivalent to a force F11, having equal value and direction directly applied to one end of the torsion bar 1 and to a twisting moment $Mt = F1xL$ applied to the end of the bar 1.

Likewise F2 is equivalent to a force F21 and to a twisting moment $Mt = F2xL$ applied to the other end of the bar.

Therefore, with reference to figure 5, the forces F11 and F21 applied to the bar ends, are necessarily balanced by a reaction F3 centered on the die and undependent on the incidence of the bar relative to the printed circuit board plane.

In fact, for a limited rotation of the bar around the application point of reaction F3, the ends 32,33 of the bar are subjected to virtual displacements having the same amplitude and opposed direction.

Correspondingly arms 7,8 are subjected to virtual rotations having the same amplitude and opposite direction so that the twisting torque developed by the bar is not changed and necessarily the load state is unchanged too.

Therefore the dissipator plate adjusts uniformly in contact with the die upper surface, irrespective of the possible incidence of the die upper surface relative to the board, with a predetermined urging force F3 which assures a controlled and uniform contact pressure.

The thermal exchange between die and plate is then provided by the tight contact and, if required, by interposing a film of silicon grease between the two elements.

A further advantage provided by the heat sink assembly is that being the preloaded state of the torsion bar caused by the interaction of the bar with the frame, when the heat sink assembly is brought in contact with the die and laid down on it without effort, the frame is spaced apart from the printed circuit of about one millimeter only.

It is therefore possible to use clamping screws 4,5 having a lenght sligtly greater than the sum of the board thickness and the depth of eylets 11,12 for properly mounting the assembly on the board.

Screws 4 and 5 can be screwed in the inserts 22,23 nearly entirely and once clamping is completed they extend beyond the board of about one millimeter only, thus avoiding possible interference with electronic components mounted on a second printed circuit board adjacent and parallel to the first one.

The mounting operation of the assembly can be performed withoud effort and without acting on the torsion arm with the certainly that no undesired stresses are applied to the die.

In fact the push on the die, originated from the preloaded status of the bar, is trasferred to the die only in the ending phase of the frame clamping to the printed circuit board and no handling of the torsion bar not of the hooking elements is required.

In order to remove the heat sink assembly from the printed circuit board it suffices to unscrew the screws 4 and 5, without acting in any way on the torsion bar. The printed circuit boards is then made free of any encumbrance caused by the heat sink and the frame.

The bar still remains in preloaded state and there is no risk of disenganging it from the frame.

A further advantage offered by the heat sink assembly shown in the figures is that by providing two pair of recesses, such as 18, symmetrically located relative to the diagonal defined by eylets 11,12, the torsion bar 1 may be positioned relative to the frame in either one or the other of two positions rotated 90° the one as to the other to allows the installation of the heat sink 3 in the frame 2 in either one or the other of two positions.

At like arrangement of the fixing elements 22,23 on the printed circuit board, which arrangement may be imposed by circuit contraints the orientation of the heat sink radiating fins may be chosen between two directions to provide the maximum dissipation effect in presence of ventilation flows having a predetermined direction.

Figures 1,2,3 shows a preferred form of embodiment and several changes can be made.

For example the frame may have a rectangular shape, not a square one, and the heat sink, obtained by die casting may be provided with non parallel radiating fins, provided they offer a rectilinear median housing to the torsion bar.

Even the fixing means of the assembly may differ from those described.

For example four eylets, rather than two, may be provided and the screw 4, insert 22 pair may be substituted by screws passing in the printed circuit board (possibly by studs too) to which the assembly is fixed by nuts.

The coupling between heat sink 3 and frame 2 may be rendered unloosable by providing hooking elements 9,10 suitably long such as to cause interference with the heat sink 3.

Eventually the frame side may have openings to allow for a ventilation flow lapping the lower surface of plate 3 contacting the die.

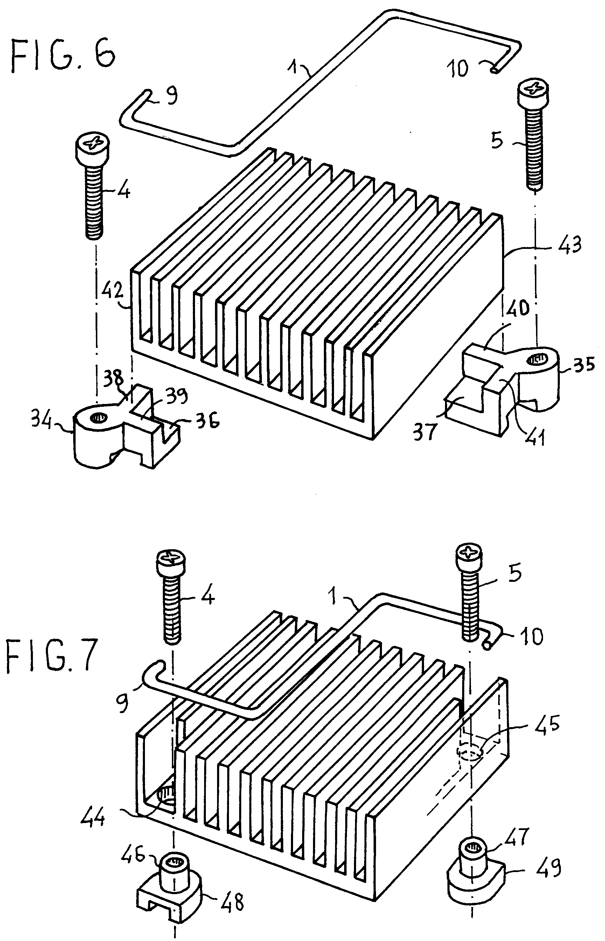

In this perspective of greater thermal exchange efficiency and minimum encumbrance, even if the use of a preloading and centering frame is preferable, the frame may be substituted by centering and preloading means as shown in figure 6.

In figure 6 two plastic elements 34,35 form each a shim having a face 36,37 respectively, resting against the lower surface of the heat sink 3, and two corner reliefs 38,39 and 40,41 respectively, which provide the positioning of the elements against two corner edges 42,43 of the heat sink.

The two elements are urged against the heat sink, by the action of the torsion bar 1, whose hooking elements are engaged in recesses similar to recess 18 of figure 1 provided in the lower surface of the shims.

In this case the torsional bar 1 preloading is provided by the cooperation of heat sink 3 with elements 34,35.

The assembly mounting on a printed circuit board is performed with screws 4,5 passing in eylets of the elements 34,35 as in the case of figure 1.

In this way a ventilation flow is allowed below the heat sink plate too.

As an extreme case, in order to minimize the passive encumbrance of the assembly or in order to maximize, at equal encumbrance on the printed circuit board, the heat sink size, it is possible to provide in the heat sink plate 3, at corner positions thereof, a pair of cylindrical seats 44,45 where two plastic guiding bushings 46,47 are inserted.

The bushings have a stop collar 48,49 acting as preloading shim and provided with a recess for housing the hooking elements 9 or 10 of the torsion bar.

Even in this case the torsional preloading of bar 1 is provided by the cooperation of heat sink plate 3 with the stop collars 48,49.

The bushing 46,47 are retained in the heat sink seats by the twisting moment exerted by the bar 1.

The clamping of the bushings, hence of the heat sink to the printed circuit board is performed by screws 4,5 as in the preceding cases.

Obviously the screws must have a head slidable in the cylindrical seats 44,45.

It is further clear that although the heat sink assembly of the present invention is expressely aimed at use with naked integrated circuits, its utility is not limited to the combination with such circuits, and the assembly can be advantageously used with any kind of integrated circuit, even packaged, where a thermally conductive package surface, plane and parallel to the supporting printed circuit board is present.

**Claims**

1. Heat sink assembly (1,2,3) for integrated circuit (19) mounted on a printed circuit board (21) comprising

- a torsion bar (1) ended with two arms (7,8) perpendicular to said bar (1) and extending in opposite direction as to said bar (1), said arms (7,8) having a free end forming a pair of hooking elements (9,10),
- a heat sink (3) formed by a high thermal conductivity plate having dissipation fins (19) forming a least a housing for said torsion bar,
- centering and preloading means (2) for centering said heat sink (3) and preloading said torsion bar (1) independently of said integrated circuit and said printed circuit board (21), said centering and preloading means (2) having a first surface for resting on said printed circuit board (21) and a second surface conjugate to surface portions of said heat sink (3), said torsion bar (1) being housed in said heat sink (3) housing, said hooking element pair (9,10) being hooked to said centering and preloading means (2) in proximity of said first surface, with a composite slide-hinge constraint preventing movement of said hooking elements (9,10) perpendicularly to said first surface, and
- removable clamping means (4,5,22,23) for removably clamping said centering and preloading means (2) to a printed circuit board (21) said clamping means providing the centering of said heat sink (3) plate relative to an integrated circuit die (19) mounted on said printed circuit board (21).

2. Heat sink assembly as in claim 1 where said centering and preloading means for centering said heat sink and preloading said bar (1) comprises a pais of shims (36,37,48,49) each inserted between said heat sink (3) plate and one of said hooking elements (9.10).

3. Heat sink assembly as in claim 1 where said centering and preloading means (2) for centering said heat sink (3) and preloading said bar (1) comprises a frame (2) housing said heat sinl plate (3).

4. Heat sink assembly as in claim 1 where said first surface of said centering and preloading means has at least a pair of recesses (18) for receiving said pair of hooking elements (9,10).

5. Heat sink assembly as in claim 1 where said clamping means comprises a pair of clamping screws (4,5) inserted in a pair of cylindrical seats (11,12) passing in said centering and preloading means (2) in proximity of said composite slide-hinge constraint of said hooking elements.

6. Heat sink assembly as in claim 3 where said frame is square.

# FIG.1

# FIG.2

# FIG.3

FIG.4

FIG.5

FIG. 6

FIG. 7

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| Y | US-A-5 019 940 (D. CLEMENS)<br>* the whole document * | 1,3,6 | H01L23/40 |
| Y | IBM TECHNICAL DISCLOSURE BULLETIN.<br>vol. 33, no. 2 , July 1990 , NEW YORK US<br>pages 218 - 219<br>'Cooling Enhancement of Intel 386/486 by Clip-on Heat Sink'<br>* the whole document * | 1,3,6 | |
| A | US-A-4 679 118 (P. JOHNSON ET AL.:)<br>* the whole document * | 1,3,6 | |
| A | US-A-3 757 271 (R. JUDGE ET AL.:) | | |

TECHNICAL FIELDS
SEARCHED    (Int.Cl.6)

H01L

The present search report has been drawn up for all claims

| Place of search | Date of completion of the search | Examiner |
|---|---|---|
| THE HAGUE | 4 March 1994 | Zeisler, P |

CATEGORY OF CITED DOCUMENTS

X : particularly relevant if taken alone
Y : particularly relevant if combined with another
     document of the same category
A : technological background
O : non-written disclosure
P : intermediate document

T : theory or principle underlying the invention
E : earlier patent document, but published on, or
     after the filing date
D : document cited in the application
L : document cited for other reasons

 

& : member of the same patent family, corresponding
     document

EPO FORM 1503 03.82 (P04C01)